# EUROPÄISCHE PATENTSCHRIFT

(11) **EP 2 978 593 B1**
(45) Veröffentlichungstag und Bekanntmachung des Hinweises auf die Patenterteilung: **27.09.2017**
(21) Anmeldenummer: 14714177.4
(22) Anmeldetag: 28.03.2014
(51) Int. Cl.: B29C 71/02, B29D 11/00, B29C 67/00, G02B 6/138, G02B 6/30, G03F 7/038, G02B 6/122, G03F 7/00

(54) **HERSTELLUNG VON 3D-FREIFORM-WELLENLEITERSTRUKTUREN**
PRODUCTION OF 3D FREE-FORM WAVEGUIDE STRUCTURES
PRODUCTION DE STRUCTURES DE GUIDE D'ONDES TRIDIMENSIONNELLES À FORMES LIBRES

(30) Priorität: 28.03.2013 DE 102013005565
(43) Veröffentlichungstag der Anmeldung: 03.02.2016
(73) Patentinhaber: Karlsruher Institut für Technologie (KIT), 76131 Karlsruhe (DE)
(72) Erfinder: MAPPES, Timo, 76135 Karlsruhe (DE); KÖBER, Sebastian, 42799 Leichlingen (DE); LINDENMANN, Nicole, 75223 Niefern (DE); KOOS, Christian, 74936 Siegelsbach (DE)
(74) Vertreter: Müller-Boré & Partner Patentanwälte PartG mbB
(86) Internationale Anmeldenummer: PCT/EP2014/000841
(87) Internationale Veröffentlichungsnummer: WO 2014/154363

(56) Entgegenhaltungen:
- EP-A1- 1 635 202
- JP-A- H07 100 938
- US-B2- 7 039 264

## Beschreibung

Die vorliegende Erfindung betrifft das Gebiet der Mikro- und Nanooptik, nämlich Wellenleiterstrukturen insbesondere zur optischen Verbindung integrierter photonischer Systeme untereinander (Chip-Chip-Verbindungen) sowie zur Verbindung integrierter photonischer Systeme zu Glasfasern (Faser-Chip-Verbindungen). Insbesondere betrifft die Erfindung ein Verfahren zur Herstellung solcher Wellenleiterstrukturen.

Das Gebiet der integrierten Photonik, insbesondere die Integration von Photonik in die etablierte Silizium-Chip-Technologie ist seit einigen Jahren ein sehr aktives Forschungsgebiet und verspricht großen praktischen Nutzen in der Kombination und Fusion von elektronischer und optischer Datenübertragung und -verarbeitung. Nanophotonische Systeme mit hoher Komplexität und einer Vielzahl von Funktionen können so auf kleinsten Raum implementiert und industriell hergestellt werden.

Allerdings stellen sich immer wieder die optischen Verbindungen zwischen einzelnen photonischen Systemen als eine wesentliche technologische Hürde bei der kommerziellen Umsetzung heraus. So werden sowohl an die Positioniergenauigkeit als auch an die Güte bzw. die optische Qualität solcher optischen Verbindungen Anforderungen gestellt, die durch Produktionsprozesse, die sich in die Fertigung hoch-integrierter Schaltungen implementieren lassen, nur schwer erreichbar sind. Jedenfalls erfordern optische Verbindungen beispielsweise auf Basis herkömmlicher Glasfasern, welche direkt an den Chip gekoppelt werden, sehr viele Arbeitsschritte, die gar nicht oder nur schwer automatisierbar sind, und führen zu vergleichsweise geringen Integrationsdichten von Chip-Chip-Verbindungen. Dies wiederum führt zu hohen Produktions- und Stückkosten.

Die Technologie der optischen Verbindungen für integrierte photonische Systeme, ist also von entscheidender Bedeutung für die Entwicklung photonischer Schaltkreise. Es gab hierzu in der Vergangenheit eine Reihe verschiedener Ansätze, die Herstellung photonischer Verbindungswellenleiter in integrierten photonischen Systemen zu verbessern.

US 5 846 694 beschreibt eine planare Strukturierung von Wellenleitern. Dabei wird zunächst ein Substrat lithographisch strukturiert, auf das das Wellenleitermaterial abgeschieden wird. Das Substrat wird derart vorstrukturiert, dass das geschmolzene Wellenleitermaterial das Substrat nur entlang des gewünschten Verlaufs der Wellenleiterstruktur benetzt, nicht aber die restliche Bauteilfläche. Ähnliche planare Wellenleiterstrukturen werden auch in EP 1 434 068 A2 und US 7 024 093 B2 vorgeschlagen. Allerdings wird dort das Wellenleitermaterial direkt planarlithographisch strukturiert. Auch in EP 2 269 103 A1 wird eine planar-lithographische Strukturierung des Wellenleitermaterials angewandt.

Ein ganz anderer Ansatz zur Herstellung eines Wellenleiters wird in DE 10 2007 038 642 B4 vorgeschlagen. Dabei wird zunächst eine dicke Schicht aus organischem Material hergestellt. Entlang eines gewünschten Verlaufs des herzustellenden Wellenleiters wird dieses organische Material mit einem fokussierten Laserstrahl so verändert, dass sich im Fokus des Laserstrahls der Brechungsindex des Materials verändert. Damit wirkt der vom Laserfokus beschriebene Pfad als Lichtwellenleiter. Dieses Verfahren ist somit anders als die voran beschriebenen Verfahren beispielsweise bezüglich des Verlaufs und der Geometrie des Wellenleiters nicht auf herkömmliche planar-lithographische Technologien angewiesen und beschränkt. Allerdings sind bei diesem Ansatz dem für die Wellenleitung nötigen Brechungsindexkontrast Grenzen gesetzt.

EP 1 635 202 A1 offenbart ein Verfahren zur Herstellung optischer Elemente mittels mehrphotonen-induzierter Polymerisation. Dabei werden ausgewählte Bereiche eines photoinduzierbaren Polymers durch eine Multi-Photonen-Anregung polymerisiert, wobei optische Elemente mit dreidimensionaler Struktur geformt werden können. Die daraus resultierenden optischen Elemente werden von dem nicht-polymerisierten Material getrennt. Manche photoinduzierbaren Polyimide werden im Rahmen einer Nachentwicklung gebacken, um eine Imidisierung zu bewirken. Außerdem können zusätzlich nicht-photoinduzierbare, thermoplastische Polymere verwendet werden, um ein semi-interpenetrierendes Polymernetzwerk mit den photoinduzierbaren Strukturen zu bewirken.

US 7 039 264 B2 offenbart ein Verfahren zur Erzeugung von monolithischen, optischen Strukturen, welche mittels einer Mehrzahl von Beschichtungen eines Substrates durch einen Partikelstrahl erzeugt werden. Durch die Verwendung eines Laserstrahls kann dabei im Partikelstrahl mittels Laserpyrolyse eine Mehrzahl von kleinsten Partikeln erzeugt werden, bevor der Partikelstrahl auf das Substrat auftrifft. Auf diese Weise können homogene Schichten von feinsten Partikeln auf dem Substrat erzeugt werden. Durch die oftmals beim Auftreffen durch die Laserpyrolyse erhitzten Partikel, können diese auf dem kühleren Substrat anhaften.

Ein technologisch besonders interessanter Ansatz für Anwendungen als Chip-Chip-Verbindungen zur optischen Verbindungen integrierter photonischer Schaltkreise untereinander wird in "Photonic wire bonding: a novel concept for chip-scale interconnects" von Lindenmann et al., Optics Express, vol. 20, Seiten 17667 ff. beschrieben. Darin wird ein fokussierter Laser verwendet, um lokal einen Photolack zu belichten und damit eine lokale Polymerisierung zu initiieren. Durch verschieben des Laserfokus innerhalb des Volumens des Photolacks "schreibt" der Laser somit die gewünschte Geometrie eines herzustellenden Wellenleiters exakt nach. Das dabei entstehende Polymer bildet somit direkt den Wellenleiter. Auch wenn dieses Verfahren aufgrund seines seriellen Prozesscharakters zeitaufwändig ist, können durch die Möglichkeit der exakten Steuerung und Führung des Laserfokus eine hohe Homogenität des Wellenleitermaterials und eine Wellenleiteroberfläche mit recht niedriger Rauhigkeit hergestellt werden.

Neben der bereits erwähnten Anforderungen an die Präzision und Güte der herstellenden Wellenleiterstrukturen, sowie deren möglichst hohe Integrationsdichte ist eine weitere Anforderung für eine kommerzielle Umsetzung die Verkürzung von Prozessierungszeiten. Während herkömmliche parallele Produktionsprozesse oft Einschränkungen in der möglichen Geometrie der Strukturen aufweisen, erfordern serielle Strukturierungstechnologie vergleichsweise lange Prozesszeiten, auch wenn die Präzision und vor allem die Flexibilität in den erreichbaren Geometrien dort besser sein können.

Aufgabe der vorliegenden Erfindung ist es, die optische Qualität von Wellenleiterstrukturen bei gleichzeitig hohem Freiheitsgrad der erreichbaren Geometrien des Wellenleiterverlaufs und bei kurzen Prozesszeiten zu verbessern. Diese Aufgabe wird durch ein Verfahren mit den in Anspruch 1 angegebenen Merkmalen gelöst. Bevorzugte Ausführungsformen sind Gegenstand der abhängigen Ansprüche.

Insbesondere bietet die Erfindung damit ein Verfahren zur Herstellung eines optischen Wellenleiters, wobei zunächst ein (optisch) polymerisierbares Material in einem nicht-polymerisierten Zustand bereitgestellt wird. Insbesondere kann dieses Material als Schicht zumindest in dem Bereich aufgebracht oder abgeschieden werden, in dem auch die Wellenleiterstruktur hergestellt werden soll. Dieses polymerisierbare Material wird dann an einer Vielzahl von Positionen lokal polymerisiert, wodurch eine Vielzahl von polymerisierten Strukturelementen erzeugt wird, welche eine Rohstruktur für den herzustellenden Wellenleiter bildet. Insbesondere bilden die polymerisierten Strukturelemente in ihrer Gesamtheit den herzustellenden Wellenleiter annähernd nach, ohne dass sie bereits die für den endgültigen Wellenleiter geforderte oder gewünschte Homogenität des Materials und die geforderte oder gewünschte Glattheit der Strukturgrenzen aufweisen. Vorzugsweise entspricht aber das Gesamtvolumen des polymerisierten Materials der erzeugten Strukturelemente, welche den herzustellenden Wellenleiter nachbilden, im Wesentlichen dem Volumen des herzustellenden Wellenleiters. Zwischen den einzelnen Strukturelemente können allerdings auch noch Lücken auftreten, in denen sich auch noch nicht polymerisiertes Material befindet. Die polymerisierten Strukturelemente werden aber entlang des gesamten Verlaufs des herzustellenden Wellenleiters erzeugt und sie hängen insbesondere so zusammen, dass sie als Rohstruktur des Wellenleiters selbst nach einer Entfernung des sie umgebenden nicht polymerisierten Materials noch ausreichend selbsttragend sind.

In einer bevorzugten Ausführungsform umfasst das lokale Polymerisieren ein Bestrahlen mit fokussiertem Laserlicht. Damit können die polymerisierten Strukturelemente besonders präzise positioniert werden. Außerdem ist durch die hohe Energiedichte des Lichts im Fokus des Laserstrahls lokal eine sehr schnelle Polymerisierung möglich. Vor allem aber kann der Fokus beliebig innerhalb eines Volumens des polymerisierbaren Materials positioniert und verändert werden, wobei der Prozess des Polymerisierens im Wesentlichen nur im Bereich des Laserfokus erfolgt. Damit lassen sich innerhalb des Volumens des polymerisierbaren Materials im Wesentlichen beliebige 3-dimensionale Freiformstrukturen bilden. Insbesondere wird der Fokus des Laserstrahls zumindest im Bereich des herzustellenden Wellenleiters vorzugsweise rasterartig relativ zu dem polymerisierbaren Material gescannt. Besonders bevorzugt werden die polymerisierten Strukturelemente entlang des Weges des Fokus als linienförmige Strukturelemente erzeugt. Vorzugsweise ist dazu ein Raster von parallelen Bearbeitungslinien vorgesehen, entlang derer der Laserfokus nacheinander bewegt wird, wobei das Laserlicht nur dort eingestrahlt wird, und damit der Polymerisierungsprozess nur dort durchgeführt wird, wo die Bearbeitungslinien innerhalb eines Volumenbereichs des polymerisierbaren Materials verlaufen, in dem der Wellenleiter hergestellt werden soll.

Nach dem lokalen Polymerisieren erfolgt ein Entfernen der nicht polymerisierten Bereiche des polymerisierbaren Materials unter Beibehaltung des polymerisierten Materials. Das nicht polymerisierte Material wird also selektiv entfernt. Dies kann beispielsweise durch einen nasschemischen Prozess mittels eines selektiv wirkenden Lösungsmittels erfolgen. Hierfür kann auf zahlreiche, aus der Lithographie bekannte Prozesse zurückgegriffen werden. Dabei bleiben die zuvor polymerisierten Bereiche als Rohstruktur des herzustellenden Wellenleiters insbesondere selbsttragend erhalten. Beispiele für polymerisierbare Materialien und entsprechende Lösungsmittel (Entwickler) werden später noch diskutiert.

Nun schlägt die Erfindung vor, das polymerisierte Material, also die entstandene Rohstruktur des Wellenleiters, so zu Erwärmen, dass die polymerisierten Strukturelemente innerhalb einer Rohstruktur eines herzustellenden Wellenleiters unter Bildung des optischen Wellenleiters fusionieren. Die Rohstruktur (also die polymerisierten Strukturelemente) wird dabei so erwärmt, dass sie aufgrund des einsetzenden Glasübergangs des polymeren (polymerisierten) Materials unter Erniedrigung der Oberflächenenergie geglättet und insbesondere im Inneren homogener wird, ohne dass das polymere Material allerdings schmilzt. Das Erwärmen erfolgt also nicht bis zur Schmelztemperatur des polymeren Materials. Dadurch bleibt also die grundsätzliche äußere Geometrie des Verlaufs der selbsttragenden Rohstruktur erhalten, während aber durch eine zumindest teilweise Homogenisierung des Inneren und eine zumindest teilweise Glättung der Oberfläche aus der Rohstruktur der gewünschte Wellenleiter gebildet wird. Temperatur und Dauer des Erwärmungsprozesse können dabei so gewählt werden, dass die gewünschte Absenkung der Oberflächenrauhigkeiten und die gewünschte Homogenisierung des Wellenleitermaterials erreicht wird.

Insbesondere umfasst das Erwärmen ein Erwärmen auf eine Temperatur oberhalb der Glasübergangstemperatur aber unterhalb der Schmelztemperatur des polymerisierten Materials. Als Glasübergangstemperatur des verwendeten Polymers wird in diesem Zusammenhang insbesondere diejenige Temperatur angesehen, bei welcher in einer dynamisch-mechanischen Analyse (DMA) der Imaginärteil (auch Verlustmodul genannt) des Elastizitätsmoduls ein Maximum erreicht. Hierzu wird ergänzend auch auf die Norm DIN EN 61006:2004-11 hingewiesen.

Die Erfindung bietet damit ein sehr flexibel an geometrische Erfordernisse anpassbares Verfahren zur Herstellung optischer Verbindungen von photonischen Bauteilen durch polymere Freiformstrukturen. Damit können insbesondere durch einen dreidimensional-direktschreibenden Lithographieprozess frei definierbare, wellenführende Strukturen zwischen insbesondere planar integrierten photonischen Bauteilen erzeugt werden. Dies liefert sowohl verlustarme optische Verbindungen zwischen integrierten photonischen Strukturen (Chip-zu-Chip Kopplung) als auch Verbindungen zwischen optischen Fasern und photonischen Strukturen (Faser-Chip Kopplung).

Das vorgeschlagene Verfahren nutzt einen lokalen Polymerisierungsprozess, der insbesondere im Fokus eines vorzugsweise gepulsten Laserstrahls vorzugsweise durch Mehrphotonenabsorption hervorgerufen wird. Der lokale Polymerisierungsprozess erlaubt die präzise Kontrolle der dreidimensionalen Struktur des zu erzeugenden Wellenleiters, indem bereits die Rohstruktur den gewünschten Verlauf des Wellenleiters nachbildet, ohne allerdings bereits die nötige oder gewünschte innere Homogenität und/oder die nötige oder gewünschte Glattheit der Oberfläche des endgültigen Wellenleiters aufweisen zu müssen. Der Polymerisierungsvorgang muss also nicht das gesamte Volumen des herzustellenden Wellenleiters lückenlos und homogen abdecken. Vielmehr können einzelne polymerisierte Strukturelemente, wie beispielsweise einzelne, entlang des Weges eines Laserfokus (hier auch als Schreiblinie bezeichnet) erzeugte polymerisierte Kanäle oder Fäden so in einem Abstand zueinander vorgesehen werden, dass lediglich ein ausreichender Überlapp des polymerisierten Materials derart entsteht, dass die gesamte, entstehende Rohstruktur auch nach Entfernen des umgebenden, nicht polymerisierten Materials noch selbsttragend ist und nicht in die einzelnen Strukturelemente zerfällt.

Insbesondere bei Verwendung eines scannenden Laserfokus führt die lokale Polymerisierung zur Erzeugung von diskreten, dreidimensional ellipsoiden Strukturen innerhalb des polymerisierbaren Materials (Photolackes), sog. Voxeln. In der Schreibrichtung, also entlang der Schreiblinien werden sog. Voxellinien in das Material geschrieben. Durch eine angepasste Belichtungsstrategie kann nun aus einer Vielzahl dieser Voxellinien eine durchgängige wellenleitende Freiformstruktur erzeugt werden. Nicht polymerisierter Photolack wird dabei in einem weiteren Prozessschritt durch einen geeigneten Entwickler von polymerisierten Bereichen abgetrennt, somit wird eine frei stehende dreidimensionale Struktur (die Rohstruktur) erzeugt.

Die vorliegende Erfindung bietet damit eine sehr effiziente Zusammenführung der Qualität der erzeugten Struktur einerseits - sowohl im Hinblick auf die Glattheit der Oberfläche als auch die Materialhomogenität innerhalb des Volumens des polymerisierten Materials - und der letztendlich zur Erzeugung des Wellenleiters notwendigen Schreibzeit bzw. Belichtungsdauer andererseits. Letztere kann bei Anwendung der vorliegenden Erfindung im Hinblick auf eine kommerzielle Nutzung der Technik vergleichsweise gering gehalten werden. So ist es möglich, der nötigen Schreibzeit durch die Wahl vergleichsweise großer Abstände zwischen Voxellinien relativ kurz zu halten, was zwangsläufig zu Inhomogenitäten im Volumen des Materials bzw. zu einer rauhen Oberfläche der Rohstruktur führt. Dies würde zwar zur Lichtstreuung und damit zu Propagationsverlusten und einer geringen optischer Leistung der entstehenden Rohstruktur führen. Durch das nachfolgende Erwärmen der Rohstruktur insbesondere über die Glasübergangstemperatur, ist es allerdings sehr effizient möglich, die gewünschten optischen Eigenschaften des Wellenleiters herzustellen.

So bietet die vorliegende Erfindung eine sehr wirksame und gleichzeitig sehr stabile und gut reproduzierbare Möglichkeit zur Vermeidung bzw. Verringerung einer optischen Verschlechterung von herzustellenden Wellenleiterstrukturen, selbst wenn diese mit großer Schreibgeschwindigkeit und entsprechend großen Abständen zwischen benachbarten Voxellinien erzeugt werden. Ein einzelner herzustellender Wellenleiter wird dabei aus einer Vielzahl einzelner, aber zumindest teilweise aneinander angrenzender bzw. überlappender polymerisierter Strukturelemente hergestellt.

In einer bevorzugten Ausführungsform wird das lokale Polymerisieren durch eine Multiphotonenabsorption optisch induziert. Der nicht-lineare optische Prozess einer Multiphotonenlithographie ermöglicht die Herstellung von 3-dimensionalen Freiformstrukturen mit besonders hoher räumliche Auflösung und schafft vorzugsweise zudem sehr scharfe Übergänge zwischen dem polymerisierten und dem nicht-polymerisierten Material. Der Multiphotonenabsorptionsprozess wird vorzugsweise durch die Verwendung eines gepulsten Lasers noch unterstützt, da gerade damit besondere hohe Energiedichten im Laserfokus erreicht werden, die diesen nicht-linearen optischen Prozess begünstigen. Dabei ist gerade für die erfindungsgemäße Vorgehensweise vorteilhaft, dass eine sehr gute selektive Entfernung des nicht-polymerisierten Materials und bei der Erwärmung eine sehr gute Fusionierung der Strukturelemente zum Wellenleiter, insbesondere hinsichtlich der erreichbaren Homogenität des Wellenleitermaterials, bewirkt wird.

Vorzugsweise erfolgt das lokale Polymerisieren entlang einer Vielzahl von in einem regelmäßigen Raster parallel zueinander verlaufenden Bearbeitungslinien innerhalb eines Bereichs des herzustellenden optischen Wellenleiters. Die Bearbeitungslinien (Schreiblinien) bilden dabei beispielsweise den Verlauf des Zentrums des Laserfokus, also das Zentrum des Pfades, entlang dessen die Polymerisierung erfolgt. Es ist also nicht notwendig (wenn in einer anderen Ausführungsform allerdings auch möglich), dass die Schreiblinien dem prinzipiellen Verlauf des herzustellenden Wellenleiters unmittelbar folgen bzw. parallel dazu verlaufen. Stattdessen können die Positionen bzw. Abstände und der Verlauf der Schreiblinien unabhängig von der frei wählbaren, dreidimensionalen Form des Wellenleiters in einem fest vorgegebenen Raster angeordnet sein. Insbesondere kann der Laserfokus beispielsweise entlang der Schreiblinien immer senkrecht zur Strahlrichtung gescannt werden.

Vorzugsweise bilden die polymerisierten Strukturelemente Linienelemente (lineare, polymerisierte Kanäle oder Fäden), welche einen Querschnitt senkrecht zu einer Längserstreckung der Linienelemente aufweisen, der im Bereich von etwa 100 nm bis etwa 2 µm liegt. Insbesondere wird der Durchmesser bzw. Querschnitt der polymerisierten Strukturelemente bzw. Linienelemente durch die wirksame Ausdehnung des Laserfokus festgelegt. Beispielsweise wird bei einer typischen Gauß'schen Intensitätsverteilung eines Laserfokus die laterale Auflösung höher, also die laterale Ausdehnung des Laserfokus geringer sein als die axiale. Die polymerisierten Strukturelemente werden daher in axialer Richtung des Laserstrahls vorzugsweise eine größere Ausdehnung aufweisen als in lateraler Richtung. Bei Schreiblinien senkrecht zur Strahlrichtung können die in axialer Richtung des Lasers zueinander benachbarten Schreiblinien einen größeren gegenseitigen Abstand aufweisen als die in lateraler Richtung benachbarten Schreiblinien. Vorzugsweise weisen benachbarte Bearbeitungslinien einen gegenseitigen Abstand im Bereich von etwa 50 nm bis etwa 3 µm, besonders vorzugsweise im Bereich von etwa 100 nm bis etwa 2 µm, noch mehr bevorzugt im Bereich von etwa 200 nm bis etwa 1 µm, am meisten bevorzugt im Bereich von etwa 200 nm bis etwa 500 nm auf. Vorzugsweise ist der mittlere Durchmesser bzw. Querschnitt des herzustellenden Wellenleiters oder dessen lokaler Durchmesser bzw. Querschnitt zumindest bereichsweise zumindest doppelt so groß wie der mittlere Durchmesser bzw. Querschnitt der einzelnen polymerisierten Strukturelemente, die den Wellenleiter bilden.

In einem weiteren bevorzugten Aspekt wird während des Erwärmens eine Atmosphäre von Dotierstoff bereitgestellt. Dieser Dotierstoff kann vorzugsweise während des Erwärmens zumindest teilweise in das polymerisierte Material eindiffundieren. Das Bereitstellen des Dotierstoffs kann auf unterschiedliche Weise erfolgen. In einer bevorzugten Ausführungsform umfasst das Verfahren vor dem Erwärmen ein Beschichten des polymerisierten Materials mit Dotierstoff. Damit erlaubt das Verfahren die Dotierung der erzeugten Freiformstrukturen mit weiteren Stoffen, um somit weitere Funktionalitäten in das Material einzufügen oder neue Funktionalität zu erzeugen. In Betracht kommt hierbei eine Vielzahl funktionaler oder passiver Materialsysteme. Passive Systeme beschreiben hierbei Materialien, die in Bezug auf das Polymer der Rohstruktur einen höheren oder niedrigeren Brechungsindex aufweisen. Aktive Komponenten wären unter anderem Licht emittierende oder nicht-linear optische oder elektro-optisch aktive Stoffe. In beiden Fällen können die Materialien sowohl organischen als auch anorganischen Ursprungs sein und durch unterschiedliche Beschichtungsmethoden auf die Rohstruktur aufgebracht bzw. in oberflächennahe Bereiche der Rohstruktur eingebracht werden. Diese Stoffe können nun im thermischen Bearbeitungsschritt durch Diffusion tiefer in das Volumen der Struktur bewegt werden. Ein zentraler Vorteil dieser Methode ist somit die Möglichkeit, Stoffe in die polymere Freiformstruktur einzubringen, die mit dem ursprünglichen Lacksystem (polymerisierbares Material bzw. Photolack und der darauf abgestimmte Entwickler) z.B. aufgrund von geringer Löslichkeit nicht kompatibel ist, oder durch den Belichtungsschritt der Multiphotonenpolymerisation beschädigt werden würde. Durch das erfindungsgemäße Verfahren können Mikrostrukturen aus Materialkombinationen erzeugt werden, die im Makroskopischen nicht kompatibel sind. Insbesondere ist es möglich, Dotanden zu verwenden, die durch eine Strukturierung des Matrixmaterials mit lithographischen Verfahren beschädigt würden.

Vorzugsweise umfasst das Verfahren außerdem nach dem Erwärmen ein Abscheiden einer Schutzschicht auf die optische Wellenleiterstruktur. Damit kann der Wellenleiter insbesondere vor nachträglichen unerwünschten mechanischen und/oder chemischen Einflüssen geschützt werden.

In einer weiteren bevorzugten Ausführungsform umfasst das polymerisierbare Material multifunktional (insbesondere bifunktional) polymerisierbares Material, in welchem eine Vielzahl von orthogonalen Polymerisierungsmechanismen anregbar sind, wobei das lokale Polymerisieren vor dem Erwärmen ein Anregen eines ersten Polymerisierungsmechanismus umfasst, und wobei das Verfahren nach dem Erwärmen ein lokales Aktivieren eines zweiten Polymerisierungsmechanismus in dem bereits polymerisierten Material umfasst. Damit kann, wie später anhand weiterer bevorzugter Ausführungsformen noch genauer beschrieben wird, beispielsweise eine weitere nachträglich Korrektur der Wellenleiterstruktur vorgenommen oder durch eine lokale Beeinflussung des Brechungsindex dessen optische Eigenschaft modifiziert werden.

Insgesamt bietet das erfindungsgemäße Herstellungsverfahren eine Reduktion von Oberflächenrauhigkeiten und Inhomogenitäten im Volumen der freistehenden Freiformstruktur durch einen zusätzlichen thermischen Bearbeitungsschritt, bei dem das polymere Material insbesondere über seine jeweilige Glasübergangstemperatur erwärmt wird. In diesem Zustand ist das polymere Material durch einen gummiartigen Zustand charakterisiert, welches zwar seinen festen Aggregatzustand und somit seine Grundstruktur beibehält, aber durch seine erhöhte Verformungsfähigkeit eine Neuorientierung von einzelnen Polymerketten erlaubt. Dieser auch als "Reflow" bezeichnete Bearbeitungsschritt erlaubt somit der Struktur, durch eine thermodynamisch günstigere Verminderung der Oberflächenenergie eine Glättung der Oberflächen und somit eine Verbesserung der Materialbeschaffenheit im Sinne der Zielanwendung zu erreichen. Eine Verringerung der mechanischen Spannung im Volumen des Materials erlaubt durch denselben Effekt eine zeitgleiche Verbesserung der Homogenität der polymeren Struktur. Da die beschriebenen Effekte auf einer Verringerung der Energie und damit des Potentials zwischen Rohstruktur und Zielstruktur beruht, ist der Prozess selbstlimitierend und endet mit dem Erreichen der gewünschten Zielstruktur. Zusätzlich können während des Reflow-Prozesses weitere Materialien durch Diffusion in die Freiformstruktur eingebracht werden.

Die Erfindung wird nachfolgend anhand von Beispielen bevorzugter Ausführungsformen mit Bezug auf die begleitenden Zeichnungen beschrieben. Dabei zeigen:
- Fig. 1A:: eine schematische Darstellung eines beispielhaften Schritts des lokalen Polymerisierens von polymerisierbarem Material zur Erzeugung einer Vielzahl von polymerisierten Strukturelementen in einem Verfahren gemäß einer bevorzugten Ausführungsform der vorliegenden Erfindung;
- Fig. 1B:: eine schematische Darstellung einer Wellenleiterstruktur nach einem Erwärmen des polymerisierten Materials zur Fusionierung der Vielzahl von polymerisierten Strukturelementen unter Bildung des optischen Wellenleiters in einem Verfahren gemäß einer bevorzugten Ausführungsform der vorliegenden Erfindung;
- Fig. 2A:: eine Rasterelektronenmikroskop-Aufnahme einer Struktur in einem Zwischenstadium eines Verfahrens zur Herstellung einer Wellenleiterstruktur gemäß einer bevorzugten Ausführungsform der vorliegenden Erfindung; und
- Fig. 2B: eine schematische Darstellung der in Fig. 2A abgebildeten Ansicht einer Rohstruktur, in der einzelne Voxellinien beispielhaft gekennzeichnet wurden.

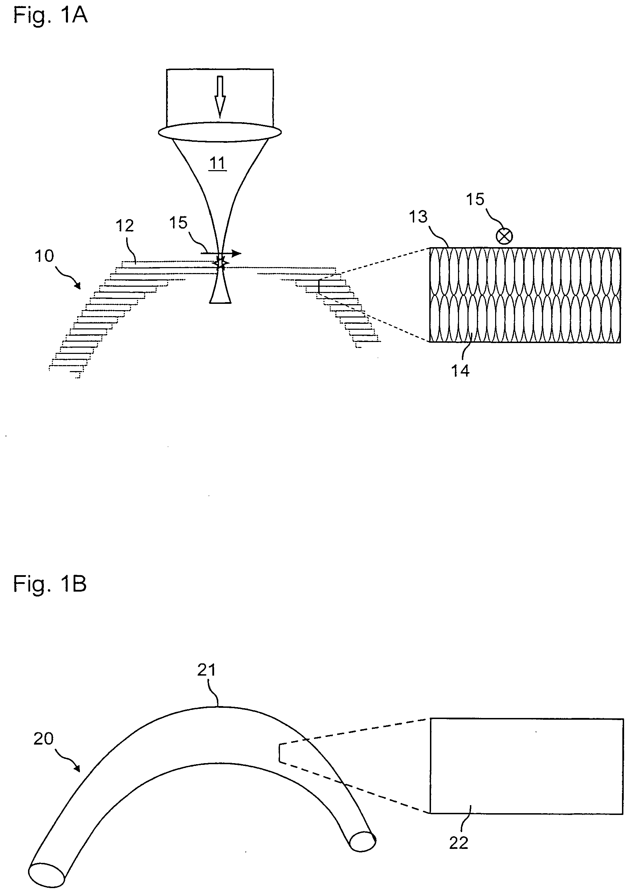

Fig. 1A zeigt eine schematische Darstellung in einem Zwischenstadium der Herstellung einer optischen Wellenleiterstruktur gemäß einer bevorzugten Ausführungsform. Insbesondere wird darin ein beispielhafter Schritt des lokalen Polymerisierens von polymerisierbarem Material zur Erzeugung einer Vielzahl von polymerisierten Strukturelementen veranschaulicht. Dazu wird zunächst einmal, dem Stadium in der Darstellung von Fig. 1A vorausgehend, zumindest in dem Bereich, in dem der optische Wellenleiter gebildet werden soll, polymerisierbares Material bereitgestellt. Beispielsweise wird dazu eine Schicht Photolack abgeschieden.

In der dargestellten bevorzugten Ausführungsform wird mittels eines fokussierten Laserstrahls 11 durch Multiphotonenlithographie in dem Photolack eine Rohstruktur 10 des herzustellenden Wellenleiters erzeugt. Dazu wird der Fokus des Laserstrahls 11 entlang einer Vielzahl von in einem regelmäßigen Raster angeordneten Schreiblinien 12 nacheinander durch den Photolack bewegt. Der Fokus scannt also gewissermaßen den Bereich, in dem der Wellenleiter hergestellt werden soll, rasterartig ab. In Fig. 1A ist dargestellt wie der Fokus des Lasers gerade entlang einer Schreibrichtung 15 von links nach rechts bewegt wird und auf seiner Spur einen Kanal mit polymerisiertem Material als polymerisiertes Strukturelement hinterlässt. Der Laserfokus baut auf diese Weise schichtweise bzw. linienweise die Rohstruktur 10 des herzustellenden Wellenleiters im Volumen des Photolacks auf.

Der im rechten Bildausschnitt von Fig. 1A dargestellte Querschnitt 13 eines bereits polymerisierten Bereichs der Rohstruktur 10 zeigt einen Querschnitt einer Vielzahl von polymerisierten Strukturelementen 14, die beispielsweise nacheinander mittels des scannenden Laserfokus während seiner Bewegung entlang der Schreibrichtung 15 erzeugt wurden. Dabei ist zu erkennen, dass die Strukturelemente 14 das Volumen des herzustellenden Wellenleiters nicht vollständig und kontinuierlich (also homogen) mit polymerisiertem Material ausfüllen müssen. Vielmehr kann die Rohstruktur 10 im Vergleich zu der in Fig. 1B dargestellten Zielstruktur 20 aus wenigen Schreiblinien 12 mit relativ großem Linienabstand bestehen. Vorzugsweise grenzen benachbarte Strukturelemente aber aneinander an und können sogar ein wenig überlappen, um eine ausreichende mechanische Stabilität der Rohstruktur 10 nach einem Entfernen des nicht polymerisierten Materials sicherzustellen.

Nach dem lokalen Polymerisieren des Photolacks wird die belichtete Struktur durch eine geeignete chemische Behandlung entwickelt. Die nach einem Entwicklungsschritt erhaltene, freistehende Rohstruktur 10 besteht hierbei aus einer Abfolge von diskreten Voxellinien 14, die bereits durch den Belichtungsschritt definiert wurde. Die gesamte Prozesszeit zur Erzeugung der Struktur wird dahingehend minimiert, dass die beschriebene Rohstruktur mit minimierter Schreibzeit und somit maximalen Abständen zweier benachbarter Schreiblinien 12 strukturiert wird. Minimale Schreibzeit bezieht sich in diesem Fall auf eine gerade ausreichende Belichtungszeit zur Erzeugung einer freistehenden selbst tragenden Grundstruktur, die bereits eine zur Zielstruktur ähnliche Formgeometrie aufweist, aber noch durch Inhomogenitäten geprägt ist.

Nach dem Entwickeln, also dem selektiven Entfernen des nicht polymerisierten Materials wird die polymere Rohstruktur 10 vorzugsweise über deren Glasübergangstemperatur erwärmt. Dies erlaubt der polymeren Struktur, durch eine Verminderung der Oberflächenenergie eine Verringerung der Oberflächenrauhigkeiten zu erreichen. Eine maximale Verringerung der Oberflächenenergie von Inhomogenitäten im Volumen der Strukturen führt durch denselben Effekt zu einer Homogenisierung der Struktur, was einer kompletten effektiven Entfernung von Strukturdetails entspricht. Die ursprünglich erzeugte, äußere dreidimensionale Form der Struktur bleibt in diesem Prozessschritt im Wesentlichen erhalten, da in den vorzugsweise verwendeten thermoplastischen Polymeren die Glasübergangstemperatur wesentlich niedriger ist als die Schmelztemperatur. Durch die selbst begrenzende erfindungsgemäße Behandlung der Rohstruktur mittels Erwärmung wird die beispielsweise die in Fig. 1B dargestellte Zielstruktur 20 mit einer im Wesentlichen glatten Oberfläche 21 und einem im Wesentlichen homogenen Inneren 22 erreicht.

In einer weiteren bevorzugten Ausführungsform wird als polymerisierbares Material multifunktional (z.B. bifunktional) polymerisierbares Material verwendet. Ein solcher entsprechend ausgelegten Resist (Photolack) könnte nun in einem optional anschließenden Prozessschritt durch Belichtung zu weiteren Vernetzungsreaktionen im Sinne eines Negativlacks angeregt werden. Bei einem entsprechend bifunktionalen Photolack können beispielsweise zwei unabhängige Vemetzungsreaktionen, sog. orthogonale Polymerisationsreaktionen, gezielt unabhängig voneinander initiiert werden. Die Initiierung der zweiten Vernetzungsreaktion, welche auf die Multiphotonenlithographie folgt und insbesondere nach dem Erwärmen ausgeführt wird, kann hierbei thermisch und/oder optisch erfolgen. Beispiele hierfür wären sowohl thermisch- wie auch photoinduzierte Diels-Alder Cycloadditionen und generell radikalisch, anionisch oder kationisch initiierte Vernetzung von geeignet substituierten Polymervorläufem. Durch diese Belichtung kann die erhaltene Zielstruktur weiter lokal oder in der Gesamtstruktur stabilisiert werden und damit günstige Eigenschaften im Hinblick auf Temperaturstabilität oder Quellverhalten in wässrigen Umgebungen annehmen.

Durch lokale Belichtung der Freiformstruktur 20 (Fig. 1B) kann durch diese Behandlung der Brechungsindex auf der Oberfläche lokal erhöht werden. Analog dazu lassen sich durch eine gezielte Auswahl des Resistsystems polymere Strukturen erzeugen, die in einem der thermischen Bearbeitung anschließenden Belichtungsschritt im Sinne eines positiven Photolacks bearbeitet werden können. Belichtete Bereiche werden dadurch vorzugsweise für einen weiteren Entwicklungsschritt löslich und können durch eine geeignete Entwicklerlösung entfernt werden. Dieser Schritt erlaubt somit eine nachträgliche Korrektur von Strukturdetails der Freiformstruktur 20. Weiterhin erlaubt diese Prozedur die lokale oberflächennahe Erniedrigung der Brechzahl der Freiformstruktur.

Das Erwärmen der Rohstruktur 10 zur Überführung in die Zielstruktur 20 erlaubt weiterhin die Dotierung der Freiformstruktur durch thermische Eindiffusion von funktionalen Materialien. Hierzu wird in einer weiteren bevorzugten Ausführungsform die Rohstruktur 10 vor dem Erwärmen in einem zusätzlichen Prozessschritt mit einem gewünschten Material beschichtet. Wie bereits oben erwähnt, kommt hierbei eine Vielzahl funktionaler oder passiver Materialsysteme in Betracht.

Nach der thermischen Behandlung der Struktur zur Überführung der Rohstruktur in die Zielstruktur und gegebenenfalls zum Eindiffundieren von Dotierstoff wird die Struktur wieder unter die Glasübergangstemperatur gekühlt, wodurch die Struktur in einem glasartigen Zustand erstarrt. Zur Passivierung der Struktur und zum Schutz gegen mögliche Umwelteinflüsse ist eine weitere Nachbehandlung möglich. Durch die Abscheidung verschiedener organischer und/oder anorganischer Schichten (Pulsed Layer Depossition, Atomic Layer Deposition, Spincoating or Drop Casting) wird dieser mechanische und chemische Schutz erreicht.

Eine beispielhafte Realisierung des hier beschriebenen Verfahrens zur Herstellung eines optischen Wellenleiters kann beispielsweise auf der Strukturierung eines negativen Photoresists zur Erzeugung eines thermoplastischen Polymers durch Zweiphotonenpolymerisation beruhen. Hier kommt als Ausführungsbeispiel z.B. eine radikalische Polymerisation von Methacrylsäuremethylester-Derivaten als Resistgrundlage in Betracht. Dieser Photolack enthält zum Erzeugen einer reaktiven Spezies vorzugsweise einen Sensibilisator zur lichtinduzierten Generierung eines Radikals bei der halben Schreibwellenlänge, so z.B. das Ketocoumarinderivat 7-Diethylamino-3-theonylcoumarin in typischen Konzentrationen von unter einem Gewichtsprozent. Dieser Photolack stellt im unbelichteten Zustand eine homogene, viskose Flüssigkeit dar. Diese wird vorzugsweise durch Auftropfen, Spincoaten oder lokales Dispensen bzw. Druckvorgänge auf ein vorgefertigtes Bauteil, auf dem der optische Wellenleiter hergestellt werden soll, aufgebracht.

Als Lichtquelle für die Lithographie wird dabei vorzugsweise ein modengekoppelter Laser eingesetzt, der bei einer Wellenlänge von 780 nm optische Pulse mit einer Breite von 120 fs und einer Wiederholrate von ca. 100 MHz abgibt. Der gepulste Laserstrahl wird vorzugsweise mit einem Objektiv hoher numerischer Apertur (z.B. 100x, NA=1.4) in das Resistmaterial fokussiert. Aufgrund der hohen Spitzenintensität des gepulsten Laserstrahls kommt es im Fokuspunkt in einem ellipsoidförmigen Bereich zu Erzeugung der reaktiven Spezies und somit zur Polymerisation. Durch eine laterale Bewegung der Probe relativ zum Fokuspunkt, bzw. des Fokuspunktes relativ zur Probe lassen sich einzelne Ellipsoide zu komplexen dreidimensionalen Strukturen kombinieren. Die laterale Auflösung des Lithographiesystems senkrecht zum Schreibstrahl (Laserstrahl) ist durch den Durchmesser des Strahls im Fokus gegeben und liegt je nach gewählter Dosis vorzugsweise zwischen etwa 150 nm und etwa 500 nm. In axialer Richtung liegt die Auflösung vorzugsweise zwischen etwa 600 nm und etwa 1500 nm. Die Laserleistung wird dabei insbesondere an die Schreibgeschwindigkeit angepasst. Für eine lineare Relativbewegung mit ca. 200 µm/s der Probe senkrecht zur Achse des Schreibstrahls werden typischerweise Schreibleistungen zwischen 10 mW und 20 mW verwendet.

Die dabei erzeugten polymerisierten Strukturelemente weisen dabei einen Linienabstand zwischen den einzelnen Schreiblinien (d.h. Abstand des Zentrums der Strukturelemente) von etwa 200 nm bis etwa 500 nm auf. Die Zielstrukturen der Verbindungswellenleiter weisen vorzugsweise einen im Wesentlichen elliptischen Querschnitt mit einer kleinen Halbachse von ca. 2 µm und einer großen Halbachse von ca. 3 µm auf. Die Oberflächenrauhigkeit der Zielstruktur liegt bevorzugt unter 10 nm.

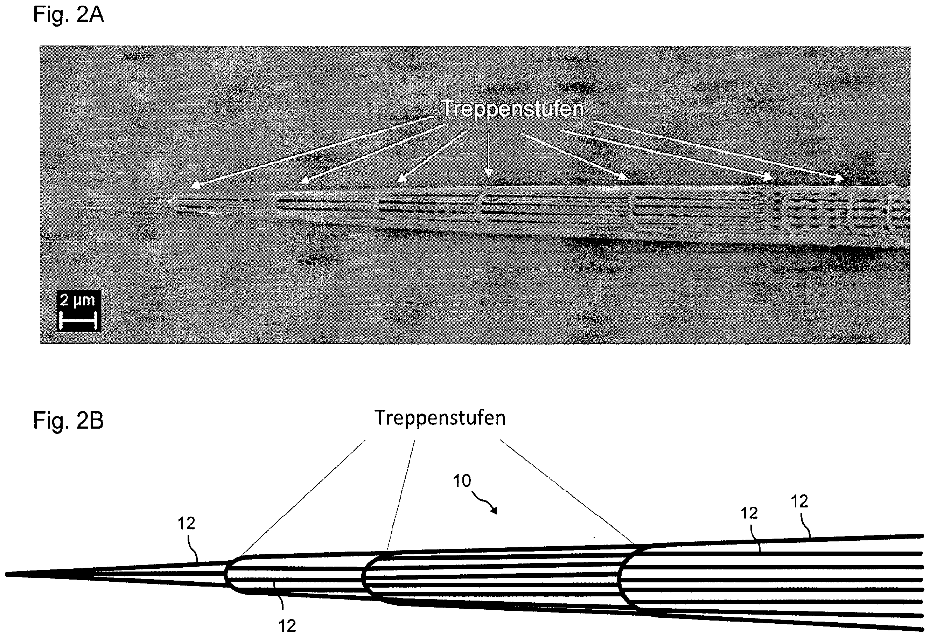

Die durch das lokale Polymerisieren erzeugte Rohstruktur wird durch einen Entwicklungsschritt von nicht-belichtetem Photolack getrennt. Die Entwicklungslösung ist in diesem Fall für jeden eingesetzten Photolack spezifisch. Für den in diesem Anwendungsbeispiel beschrieben Photolack kommt insbesondere eine alkalische Entwicklerlösung, z.B. eine 1%ige Sodalösung in Betracht. Eine durch Zweiphotonenlithographie erzeugte und entwickelte Rohstruktur ist als Rasterelektronenmikroskopaufnahme in Fig. 2A dargestellt und als schematische Wiedergabe der vergleichbaren Ansicht der Rohstruktur 10 in Fig. 2B nochmals veranschaulicht. Deutlich können hier die Abstände zwischen den einzelnen Voxellinien 12 beobachtet werden, ebenso ist eine Rauigkeit der Schreiblinien zu beobachten. Diese Beschaffenheit würde in der Anwendung als optischer Wellenleiter zu signifikanten Verlusten der geführten optischen Leistung führen. Wird zur Erzeugung der Struktur ein Resistmaterial eingesetzt, das im polymerisierten Zustand thermoplastische Eigenschaften aufweist, so ermöglicht das erfindungsgemäße Verfahren eine Glättung der Oberfläche und eine Homogenisierung der Struktur.

Die durch Multiphotonenlithographie erzeugten Strukturen werden dazu in einem nachfolgenden Bearbeitungsschritt insbesondere über die Glasübergangstemperatur der polymeren Struktur erwärmt, in dem vorliegenden Fall ca. 105-120°C. Das Polymer befindet sich hier in einem gummiartigen Zustand. Im bevorzugten Fall wird das gesamte Bauteil erwärmt, was durch eine Heizplatte einen Ofen oder durch eine Heizlampe erreicht werden kann. In einer besonders bevorzugten Ausführungsform wird nur die betreffende, polymerisierte Struktur erwärmt. Hierzu bieten sich insbesondere Verfahren an, die eine lokal begrenzte, selektive Zuführung von Wärmeenergie in die Resiststruktur erlauben. Dies kann beispielsweise durch Bestrahlung mit Licht bei Wellenlängen geschehen, die vom Resistmaterial besonders stark absorbiert werden, während das Umgebungsmaterial für diese Wellenlängen transparent ist oder Licht dieser Wellenlänge zumindest weniger absorbiert. Bei Resistmaterialien mit einem hohen Anteil von C-H-Bindungen bieten sich beispielsweise Wellenlängen von ca. 3390 nm, 1700 nm, 1130 nm oder 850 nm an, die den fundamentalen Resonanzfrequenzen bzw. den Oberschwingungen dieser Bindungen und damit den Absorptionsbanden des Materials entsprechen. Durch die Wahl von Wellenlängen im Infraroten (z.B. 1700 nm) kann eine Absorption des Lichtes in den zu verbindenden Halbleiterchips und damit ein unerwünschter Wärmeeintrag vermieden werden.

Nach Erreichen der Zielstruktur durch die thermische Behandlung wird das Bauteil und damit die Freiformstruktur bzw. eine auf dem Bauteil erzeugte Anzahl an Freiformstrukturen durch Verringern der Bauteiltemperatur auf Raumtemperatur in seinen Glaszustand überführt. Dies wird bevorzugt durch aktives Abkühlen des Bauteils durch einen Thermistor oder durch passives Abkühlen auf einem geeigneten Metallblock, z.B. Kupfer erreicht. Die erhaltene Zielstruktur hat im bevorzugten Zustand eine Oberflächenrauhigkeit von nicht mehr als 5 nm, im besonders bevorzugten Zustand eine Oberflächenrauhigkeit von nicht mehr als 1 nm. Im besonders bevorzugten Zustand ist der Kern (d.h. das Innere) der Freiformstruktur ohne Struktur und somit homogen. Im Falle eines Freiformwellenleiters ("Photonischer Wirebond") führt die thermisch induzierte Glättung der Oberfläche bzw. die Homogenisierung im Volumen des Materials zu einer Verringerung der Propagationsverluste. Diese betragen nach der Behandlung bevorzugt weniger als 10 dB/mm, besonders bevorzugt weniger als 1 dB/mm, und ganz besonders bevorzugt weniger als 0.1 dB/mm.

Eine zusätzliche Funktionalität des polymerisierbaren Materials zu dessen weiterer Bearbeitung nach dessen thermischer Bearbeitung (Erwärmen) kann z.B. durch eine chemische Ausführung des Polymervorläufers im Photolack realisiert werden. Das aus dem Methacrylsäuremethylester-Derivat erhaltene Polymer kann beispielsweise durch Verfahren wie DUV-Lithographie (deep ultraviolet, λ = 240 - 250 nm), Mehrphotonen- oder Elektronenstrahllithographie im Sinne eines Positivlacks bearbeitet werden. Belichtete Strukturdetails werden in einer alkalischen Entwicklerlösung löslich und erlauben eine Korrektur von Strukturdetails. Analog können weitere Lithographieschritte im Sinne einer zusätzlichen orthogonalen Polymerisation erzeugt werden. Als Ausführungsbeispiel kann der auf Methacrylsäuremethylester basierende Photolack teilweise oder in seiner Gesamtheit durch Derivate wie Methacrylsäureglycidylester ersetzt werden.

Zusammen mit einem entsprechenden Sensibilisator, hier eine Photosäure wie OPPI (([4-(Octyloxy)phenyl]phenyl-iodoniumhexafluoroantimonat), kann nun eine zur Multiphotonenlithographie orthogonale Polymerisierungsreaktion durch geeignete Belichtung (z.B. λ > 400 nm) gestartet werden. Diese Reaktion führt vorzugsweise zu einer chemischen Kreuzvemetzung in der Freiformstruktur und erhöht somit sowohl die thermische Stabilität der Struktur durch eine Erhöhung der Glasübergangstemperatur als auch die chemische Beständigkeit und bedingt eine Erniedrigung des Quellverhaltens der Struktur in flüssiger Umgebung.

Die oben erwähnte Dotierung der Rohstruktur beim Erwärmen kann durch passive Materialien Metall- oder Halbmetalloxide wie HfO₂, MgO, ZrO₂, Al₂O₃ oder TiO₂ erfolgen. Diese Materialien können beispielsweise durch Abscheidungstechniken wie ALD (atomic layer deposition) in Form dünner Schichten auf die Rohstruktur aufgebracht werden. Alternativ lassen sich aber auch Nanopartikel auf der Oberfläche der Rohstruktur anlagern und durch thermische Diffusion ins Innere der Struktur überführen. Das Anlagern und die Eindiffusion lassen sich durch geeignete Oberflächenfunktionalisierungen der Nanopartikel unterstützen. Aktive Materialien können Laserfarbstoffe wie Rhodamin 6G, Fluoreszenzfarbstoffe wie Cynine3 (Cy3) oder nichtlinear-optische Chromophore wie Derivate der p-Nitroanilin-Familie sein (lineare push-pull Chromphore, generell Donor-Akzeptor substituierte π-Elektronensysteme). Diese Materialien werden beispielsweise aus einem Lösungsmittel, welches vorzugsweise die vorgefertigte polymere Rohstruktur nicht beeinträchtigt, oder aus der Dampfphase auf die Struktur aufgebracht.

Durch das erfindungsgemäße Herstellungsverfahren kann insbesondere eine sehr große Freiheit in der geometrischen Gestalt bzgl. des dreidimensionalen Aufbaus bzw. Verlaufs der optischen Wellenleiterstruktur erreicht werden. Dabei kann das verwendete Lacksystem (polymerisierbares Material) abhängig vom Belichtungsverfahren als Positiv- und/oder als Negativlack dienen. Vorzugsweise weist der verwendete Photolack bi-funktionale Eigenschaften bzgl. der Strukturierung auf und erlaubt orthogonale Polymerisationsverfahren zur Erzeugung und der anschließenden, weiteren Bearbeitung der Struktur auf. Damit kann eine zweite Vernetzungsreaktion initiiert werden. Diese wird vorzugsweise in einem dedizierten zweiten Belichtungsschritt initiiert. Besonders bevorzugt ist der Photolack (bzw. das polymerisierbare Material) derart ausgestaltet, dass eine weitere Vernetzungsreaktion das Aufwachsen von Beschichtungen in erlaubt. In einem weiteren bevorzugten Aspekt erlaubt die weitere Belichtung von Teilbereichen der Zielstruktur 20 eine lokale Änderung der physikalischen und/oder chemischen Eigenschaften des Wellenleiters bzw. der Wellenleiteroberfläche 21. Das Lacksystem ist vorzugsweise so ausgelegt, dass durch einen zweiten Belichtungsschritt die in einem ersten Belichtungsschritt erzeugte Struktur im Sinne eines Positivlackes nachbearbeitet werden kann. Dieses erlaubt insbesondere die nachträgliche Korrektur von Strukturdetails. In einer weiteren bevorzugten Ausführungsform ist das Lacksystem so ausgelegt, dass durch eine zweite Belichtung die Brechzahl der Struktur lokal erhöht oder vermindert werden kann.

Wie bereits ausgeführt, werden in einer bevorzugten Ausführungsform während der thermischen Behandlung (Erwärmung) funktionelle Materialien durch temperaturinduzierte Diffusion in das Volumen der Struktur eingebracht. Das einzulagernde Material wird dazu zwischen dem Entfernen des nicht polymerisierten Materials (also dem Freilegen der Rohstruktur) und dem Erwärmen an die Oberfläche der Rohstruktur 10 angelagert bzw. durch einen Diffusionsprozess in oberflächennahe Bereiche von Struktur 10 eingelagert. Bei den einzulagernden Materialien handelt es sich vorzugsweise um im Verhältnis zum Resistmaterial hoch- oder niedrigbrechende, lichtemittierende, nichtlinear-optische und/oder elektro-optisch aktive Substanzen organischen und/oder anorganischen Ursprungs. Vorzugsweise handelt es sich bei den einzulagernden Materialien um Substanzen, die keine oder eine lediglich geringe Löslichkeit im Resistmaterial aufweisen und deren Einlagerung ausschließlich über Diffusionsprozesse in oberflächennahe Bereiche der Struktur möglich ist.

### Bezugszeichenliste

- 10: Rohstruktur (Vielzahl von Strukturelementen)
- 11: Belichtungssystem (fokussierter Laserstrahl)
- 12: polymerisiertes Linienelement (Voxellinie)
- 13: Ausschnitt des Querschnitts der Rohstruktur
- 14: Querschnitt eines Strukturelements (Voxellinie)
- 15: Schreibrichtung
- 20: Zielstruktur (Wellenleiter)
- 21: (glatte) Oberfläche der Zielstruktur
- 22: homogenes Strukturvolumen

## Patentansprüche

1. Verfahren zur Herstellung eines optischen Wellenleiters (20), umfassend:
- Bereitstellen von polymerisierbarem Material;
- lokales Polymerisieren des polymerisierbaren Materials zur Erzeugung einer Vielzahl von polymerisierten Strukturelementen (14);
- Entfernen der nicht polymerisierten Bereiche des polymerisierbaren Materials; und
**gekennzeichnet durch** den Schritt:
- Erwärmen des polymerisierten Materials zur Fusionierung der Vielzahl von polymerisierten Strukturelementen (14) unter Bildung des optischen Wellenleiters (20).

2. Verfahren nach Anspruch 1, wobei das lokale Polymerisieren durch eine Mehrphotonenabsorption optisch induziert wird.

3. Verfahren nach Anspruch 1 oder 2, wobei das lokale Polymerisieren ein Bestrahlen mit fokussiertem, insbesondere gepulstem Laserlicht umfasst.

4. Verfahren nach einem der Ansprüche 1 bis 3, wobei das lokale Polymerisieren entlang einer Vielzahl von in einem regelmäßigen Raster parallel zueinander verlaufenden Bearbeitungslinien innerhalb eines Bereichs des herzustellenden optischen Wellenleiters erfolgt.

5. Verfahren nach Anspruch 4, wobei benachbarte Bearbeitungslinien einen gegenseitigen Abstand im Bereich von etwa 50 nm bis etwa 3 µm, vorzugsweise im Bereich von etwa 100 nm bis etwa 2 µm, noch mehr bevorzugt im Bereich von etwa 200 nm bis etwa 1 µm, am meisten bevorzugt im Bereich von etwa 200 nm bis etwa 500 nm aufweisen.

6. Verfahren nach einem der Ansprüche 1 bis 5, wobei die polymerisierten Strukturelemente Linienelemente bilden, welche einen Querschnitt senkrecht zu einer Längserstreckung der Linienelemente aufweisen, der im Bereich von etwa 100 nm bis etwa 2 µm liegt.

7. Verfahren nach einem der Ansprüche 1 bis 6, wobei das Erwärmen ein Erwärmen auf eine Temperatur oberhalb der Glasübergangstemperatur des polymerisierten Materials umfasst.

8. Verfahren nach einem der Ansprüche 1 bis 7, welches außerdem während des Erwärmens eine Atmosphäre mit Dotierstoff bereitstellt.

9. Verfahren nach einem der Ansprüche 1 bis 8, welches außerdem nach dem Erwärmen ein Abscheiden einer Schutzschicht auf die optische Wellenleiterstruktur umfasst.

10. Verfahren nach einem der Ansprüche 1 bis 9, wobei das polymerisierbare Material multifunktional polymerisierbares Material umfasst, in welchem eine Vielzahl von orthogonalen Polymerisierungsmechanismen anregbar sind, wobei das lokale Polymerisieren vor dem Erwärmen ein Anregen eines ersten Polymerisierungsmechanismus umfasst, und wobei das Verfahren nach dem Erwärmen ein lokales Aktivieren eines zweiten Polymerisierungsmechanismus in dem bereits polymerisierten Material umfasst.

## Claims

1. A method for producing an optical waveguide (20), comprising:
- providing polymerizable material;
- locally polymerizing the polymerizable material to produce a plurality of polymerized structural elements (14);
- removing the unpolymerized regions of the polymerizable material; and
**characterized by** the step of:
- heating the polymerized material for fusing the plurality of polymerized structural elements (14) thus forming the optical waveguide (20).

2. The method according to claim 1, wherein the local polymerization is optically induced by multi-photon absorption.

3. The method according to claim 1 or 2, wherein the local polymerization comprises irradiation with focused, in particular pulsed laser light.

4. The method according to one of claims 1 to 3, wherein the local polymerization is carried out along a plurality of machining lines running parallel to each other in a regular grid within a range of the optical waveguide to be produced.

5. The method according to claim 4, wherein adjacent machining lines have a mutual spacing in the range of about 50 nm to about 3 µm, preferably in the range of about 100 nm to about 2 µm, even more preferably in the range of about 200 nm to about 1 µm, most preferably in the range of about 200 nm to about 500 nm.

6. The method according to one of claims 1 to 5, wherein the polymerized structure elements form the line elements having a cross section perpendicular to a longitudinal extension of the line elements, which is in the range of about 100 nm to about 2 µm.

7. The method according to one of claims 1 to 6, wherein heating comprises heating to a temperature above the glass transition temperature of the polymerized material.

8. The method according to one of claims 1 to 7, which further provides an atmosphere with a dopant during heating.

9. The method according to one of claims 1 to 8, which further comprises depositing a protective layer on the optical waveguide structure after heating.

10. The method according to one of claims 1 to 9, wherein the polymerizable material comprises multi-functional polymerizable material in which a plurality of orthogonal polymerization mechanisms can be excited, wherein the local polymerization comprises exciting a first polymerization mechanism prior to heating, and wherein the method comprises locally activating a second polymerization mechanism in the already polymerized material after heating.

## Revendications

1. Procédé permettant la fabrication d'un guide d'ondes optiques (20), comprenant le fait de :
- fournir un matériau polymérisable ;
- polymériser localement le matériau polymérisable afin de générer une pluralité d'éléments structuraux polymérisés (14) ;
- éliminer les zones non polymérisées du matériau polymérisable ; et
**caractérisé par** l'étape suivante consistant à :
- chauffer le matériau polymérisable pour la fusion de la pluralité d'éléments structuraux polymérisés (14) en formant ainsi le guide d'ondes optiques (20).

2. Procédé d'après la revendication 1, sachant que la polymérisation locale est induite de manière optique par une absorption multi-photonique.

3. Procédé d'après la revendication 1 ou 2, sachant que la polymérisation locale comprend une irradiation par une lumière laser focalisée, notamment pulsée.

4. Procédé d'après une des revendications de 1 à 3, sachant que la polymérisation locale est produite le long d'une pluralité de lignes de traitement, qui s'étendent dans un réseau régulier parallèlement l'une par rapport à l'autre, à l'intérieur d'un domaine du guide d'ondes optiques qui est à fabriquer.

5. Procédé d'après la revendication 4, sachant que des lignes de traitement adjacentes présentent un écart réciproque dans le domaine d'environ 50 nm jusqu'à environ 3 µm, de préférence dans le domaine d'environ 100 nm jusqu'à environ 2 µm, de préférence encore dans le domaine d'environ 200 nm jusqu'à environ 1 µm, et de manière préférée entre toutes dans le domaine d'environ 200 nm jusqu'à environ 500 nm.

6. Procédé d'après une des revendications de 1 à 5, sachant que les éléments structuraux polymérisés forment des éléments linéaires, qui présentent une section transversale, orthogonalement par rapport à l'extension longitudinale des éléments linéaires, qui se trouve dans le domaine d'environ 100 nm jusqu'à environ 2 µm.

7. Procédé d'après une des revendications-de 1 à 6, sachant que le chauffage comprend un chauffage à une température au-dessus de la température de transition vitreuse du matériau polymérisé.

8. Procédé d'après une des revendications de 1 à 7, fournissant en outre une atmosphère avec un agent dopant pendant le chauffage.

9. Procédé d'après une des revendications de 1 à 8, comprenant en outre un dépôt d'une couche de protection sur la structure de guide d'ondes optiques après le chauffage.

10. Procédé d'après une des revendications de 1 à 9, sachant que le matériau polymérisable comprend un matériau polymérisable de manière multifonctionnelle, dans lequel peut être initiée une pluralité de mécanismes de polymérisation orthogonaux, sachant que la polymérisation locale comprend avant le chauffage l'initiation d'un premier mécanisme de polymérisation, et sachant que le procédé comprend après le chauffage une activation locale d'un deuxième mécanisme de polymérisation dans le matériau déjà polymérisé.
